# EUROPEAN PATENT APPLICATION

(11) **EP 4 585 944 A1**
(43) Date of publication of application: **16.07.2025**
(21) Application number: 24815688.7
(22) Date of filing: 08.04.2024
(51) Int. Cl.: G01R 31/367, G01R 31/396, G01R 31/392, G01R 31/382, G01R 19/165, G01R 19/10, G01R 31/52, H02J 7/00, H01M 10/052

(54) **APPARATUS AND METHOD FOR DIAGNOSING BATTERY STATE**

(30) Priority: 26.05.2023 KR 20230068267; 05.04.2024 KR 20240046605
(71) Applicant: LG Energy Solution, Ltd., Seoul 07335 (KR)
(72) Inventor: KANG, Juyoung, Daejeon 34122 (KR); PARK, Heungil, Daejeon 34122 (KR); SEO, Jungoh, Daejeon 34122 (KR); LEE, Dajin, Daejeon 34122 (KR); CHO, Inhwan, Daejeon 34122 (KR)
(74) Representative: Goddar, Heinz J.
(86) International application number: PCT/KR2024/004596
(87) International publication number: WO 2024/248309

(57) **Abstract**

Disclosed is an energy storage system which may includes a plurality of batteries; one or more power conversion system (PCS) connected with the batteries; and a control apparatus configured to monitor whether a fire occurs in the plurality of batteries.

Here, the control apparatus may determine one or more second batteries within a predetermined distance range from a first battery where a fire has occurred and controls the one or more PCSs so that power stored in the one or more second batteries is discharged.

## Description

### [Technical Field]

This application claims priority to and the benefit of Korean Patent Application No. 10-2023-0121055 filed in the Korean Intellectual Property Office on September 12, 2023 and Korean Patent Application No. 10-2024-0118889 filed in the Korean Intellectual Property Office on September 3, 2024 the entire contents of which are incorporated herein by reference.

The present invention relates to an energy storage system and a controlling method thereof, and more particularly, to an energy storage system capable of preventing spread of fire when a fire occurs within a battery system and a controlling method thereof.

### [Background Art]

Secondary batteries, capable of recharging and reuse, may be used as an energy source for small devices such as mobile phones, tablet PCs and vacuum cleaners, and also used as an energy source for medium and large devices such as personal mobility, automobiles, and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices such as ESS for smart grids, a high-capacity battery system with multiple battery racks connected in parallel may be applied to satisfy required capacity of the device.

If a fire occurs within a high-capacity battery system, the fire may spread from the ignited battery to surrounding batteries, which may develop into a large-scale fire accident. In order to prevent the spread of fire within a battery system, a certain amount of space is generally formed between the batteries, or a fire extinguishing system is applied within the battery system.

However, in case this general fire spread prevention design is applied to a battery system, the energy density of the energy storage system decreases and the system design cost increases.

Therefore, an appropriate fire spread prevention technology that may solve these problems is required.

### [Detailed Description of the Invention]

### [Technical Problem]

To obviate one or more problems of the related art, embodiments of the present disclosure provide an energy storage system capable of preventing spread of fire when a fire occurs within a battery system.

To obviate one or more problems of the related art, embodiments of the present disclosure also provide a apparatus of controlling the energy storage system.

To obviate one or more problems of the related art, embodiments of the present disclosure also provide a method of controlling the energy storage system.

### [Technical Solution]

In order to achieve the objective of the present disclosure, an energy storage system according to an embodiment of the present invention may include a plurality of batteries; one or more power conversion system (PCS) connected with the batteries; and a control apparatus configured to monitor whether a fire occurs in the plurality of batteries.

Here, the control apparatus may determine one or more second batteries within a predetermined distance range from a first battery where a fire has occurred and controls the one or more PCSs so that power stored in the one or more second batteries is discharged.

The control apparatus may control so that charge and discharge paths of the remaining batteries except for the one or more second batteries are blocked and controls so that power stored in the one or more second batteries is discharged to an AC link side through the PCS.

The control apparatus may select one or more third batteries that are chargeable among the batteries except for the first and the one or more second batteries and controls the power stored in the one or more second batteries to be discharged toward the one or more third batteries.

The control apparatus may control one or more PCSs connected to a DC link of the batteries into stop mode and controls one or more DC/DC converters which are connected with the one or more second batteries into discharge mode, thereby discharging the power stored in the one or more second batteries toward the one or more third batteries.

The control apparatus may control one or more PCSs connected to a DC link of the batteries into stop mode and controls one or more DC/DC converters which are connected with the one or more third batteries into charge mode, thereby discharging the power stored in the one or more second batteries toward the one or more third batteriess.

The control apparatus may control one or more PCSs connected to the one or more second batteries into discharge mode and controls the PCS connected to the one or more third batteries into charge mode, thereby discharging the power stored in the one or more second batteries toward the one or more third batteries.

The control apparatus may define a discharge priority for each of a plurality of second batteries and controls the plurality of second batteries to be sequentially discharged according to the discharge priority. Here, the control apparatus may define the discharge priority based on at least one of a state of charge (SOC), a state of Health (SOH), and a distance from the first battery.

The control apparatus may monitor temperature of the first battery and controls the discharge of the second batteries to be stopped when the temperature of the first battery falls below a predetermined temperature.

According to another embodiment of the present disclosure, a control apparatus of an energy storage system including a plurality of batteries and one or more power conversion system (PCS) connected with the plurality of batteries may include at least one processor; and a memory configured to store at least one instruction executed by the at least one processor.

The at least one instruction may include an instruction to monitor whether a fire has occurred in the plurality of batteries; an instruction to, upon detecting fire occurred, determine a first battery in which a fire has occurred, among the plurality of batteries; an instruction to determinine one or more second batteries within a predetermined distance range from the first battery; and an instruction to control power stored in the one or more second batteries to be discharged.

The instruction to control power stored in the one or more second batteries to be discharged may include an instruction to control charge and discharge paths of the remaining batteries, except for the second batteries, to be blocked; and an instruction to control power stored in the second batteries to be discharged to an AC link side through the PCS.

The instruction to control power stored in the one or more second batteries to be discharged may include an instruction to select one or more third batteries that are chargeable among the batteries except for the first and the one or more second batteries; and an instruction to control the power stored in the one or more second batteries to be discharged toward the one or more third batteries.

The instruction to control power stored in the one or more second batteries to be discharged may include an instruction to control one or more PCSs connected to a DC link of the batteries into stop mode and to control one or more DC/DC converters which are connected with the one or more second batteries into discharge mode, thereby discharging the power stored in the one or more second batteries toward the one or more third batteries.

The instruction to control power stored in the one or more second batteries to be discharged may include an instruction to control one or more PCSs connected to a DC link of the batteries into stop mode and to control one or more DC/DC converters which are connected with the one or more third batteries into charge mode, thereby discharging the power stored in the one or more second batteries toward the one or more third batteriess.

The instruction to control power stored in the one or more second batteries to be discharged may include an instruction to control one or more PCSs connected to the one or more second batteries into discharge mode and to control the PCS connected to the one or more third batteries into charge mode, thereby discharging the power stored in the one or more second batteries toward the one or more third batteries.

The instruction to control power stored in the one or more second batteries to be discharged may include an instruction to define a discharge priority for each of a plurality of second batteries; and an instruction to control the plurality of second batteries to be sequentially discharged according to the discharge priority. Here, the instruction to define the discharge priority may include an instruction to define the discharge priority based on at least one of a state of charge (SOC), a state of Health (SOH), and a distance from the first battery.

The instruction to control the plurality of second batteries to be sequentially discharged may include an instruction to monitor temperature of the first battery; and an instruction to control the discharge of the plurality of second batteries to be stopped when the temperature of the first battery falls below a predetermined temperature.

According to another embodiment of the present disclosure, a control method of an energy storage system, including a plurality of batteries and one or more power conversion system (PCS) connected with the plurality of batteries, may include monitoring whether a fire has occurred in the plurality of batteries; upon detecting fire occurred, determining a first battery in which a fire has occurred, among the plurality of batteries; determining one or more second batteries within a predetermined distance range from the first battery; and controlling power stored in the one or more second batteries to be discharged.

The controlling power stored in the one or more second batteries to be discharged may include controlling charge and discharge paths of the remaining batteries, except for the second batteries, to be blocked; and controlling power stored in the second batteries to be discharged to an AC link side through the PCS.

The controlling power stored in the one or more second batteries to be discharged may include selecting one or more third batteries that are chargeable among the batteries except for the first and second batteries; and controlling the power stored in the second batteries to be discharged toward the one or more third batteries.

The controlling power stored in the one or more second batteries to be discharged may include controlling one or more PCSs connected to a DC link of the batteries into stop mode and controlling one or more DC/DC converters which are connected with the one or more second batteries into discharge mode, thereby discharging the power stored in the one or more second batteries toward the one or more third batteries.

The controlling power stored in the one or more second batteries to be discharged may include controlling one or more PCSs connected to a DC link of the batteries into stop mode and controlling one or more DC/DC converters which are connected with the one or more third batteries into charge mode, thereby discharging the power stored in the one or more second batteries toward the one or more third batteriess.

The controlling power stored in the one or more second batteries to be discharged may include controlling one or more PCSs connected to the one or more second batteries into discharge mode and controlling the PCS connected to the one or more third batteries into charge mode, thereby discharging the power stored in the one or more second batteries toward the one or more third batteries.

The controlling power stored in the one or more second batteries to be discharged may include defining a discharge priority for each of a plurality of second batteries; and controlling the plurality of second batteries to be sequentially discharged according to the discharge priority. Here, the defining the discharge priority may include defining the discharge priority based on at least one of a state of charge (SOC), a state of Health (SOH), and a distance from the first battery.

The controlling the plurality of second batteries to be sequentially discharged may include monitoring temperature of the first battery; and controlling the discharge of the plurality of second batteries to be stopped when the temperature of the first battery falls below a predetermined temperature.

### [Advantageous Effects]

According to embodiments of the present disclosure, the spread of the fire can be prevented and damage caused by the fire can be minimized even if the fire spreads to surrounding batteries, by forcibly discharging batteries located around a battery where a fire has occurred.

### [Brief Description of the Drawings]

FIG. 1 is a block diagram of a general energy storage system.
FIG. 2a is a block diagram of an energy storage system according to an embodiment of the present invention.
FIG. 2b is a block diagram of an energy storage system according to another embodiment of the present invention.
FIG. 3 is an operational flowchart of a control method of an energy storage system according to embodiments of the present invention.
FIG. 4 is a reference diagram for explaining a method for determining a second battery according to embodiments of the present invention.
FIGS. 5 to 8 are reference drawings for explaining a control method of an energy storage system according to embodiments of the present invention.
FIG. 9 is an operational flowchart of a control method of an energy storage system according to another embodiment of the present invention.
FIGS. 10 to 13 are reference diagrams for explaining a control method of an energy storage system according to another embodiment of the present invention.
FIG. 14 is a block diagram of a control apparatus of an energy storage system according to embodiments of the present invention.

100, 100': battery
200, 200': power conversion system
300, 300': control apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

State of Charge (SOC) refers to a current state of charge of a battery, represented in percent points [%], and State of Health (SOH) may be a current condition of a battery compared to its ideal or original conditions, represented in percent points [%].

A battery rack refers to a system of a structure assembled by connecting module units in series/parallel, module units being set by a battery manufacturer, which may be monitored and controlled by a battery management system (BMS). A battery rack may include several battery modules and a battery protection unit or any other protection device.

A battery bank refers to a group of large-scale battery rack systems configured by connecting several racks in parallel. A bank BMS for a battery bank may monitor and control several rack BMSs, each of which manages a battery rack.

A battery system controller (BSC) refers to a device that controls the topmost level of a battery system including a battery bank level structure or a multiple bank level structure.

Nominal capacity (Nominal Capa.) may refer to a set capacity [Ah] of battery determined by a battery manufacturer during battery development.

Hereinafter, exemplary embodiments of the present invention will be described in detail with reference to the accompanying drawings.

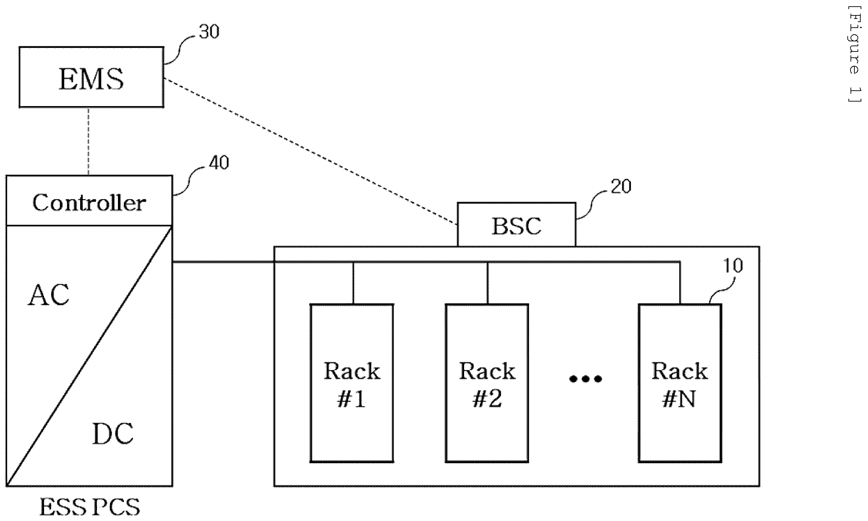

FIG. 1 is a block diagram of a general energy storage system.

In an energy storage system (ESS), a basic unit of battery for storing energy or power is a battery cell. Typycally, a seris/parallel combination of battery cells may form a battery module and multiple battery module may form a battery rack. In other words, a battery rack as a series/parallel combination of battery modules may be a basic unit of a battery system. Here, a battery module may be referred to as a battery pack depending on a device or a system in which the battery is used.

Referring to FIG. 1, a battery rack 10 may include multiple battery modules. A battery rack may be monitored and managed through a rack battery management system (rack BMS). The RBMS may monitor a current, a voltage and a temperature of each battery rack to be managed, calculate a state Of charge (SOC) of the battery based on a monitoring result, and control charging and discharging.

A battery system controller (BSC) 20 may be located in each battery section which includes a plurality of batteries, peripheral circuits, and devices to monitor and control objects such as a voltage, a current, a temperature, and a circuit breaker. The battery system controller is a top-level controller of a bank-level battery system including multiple battery racks and is also used as a controller in a battery system with a multiple bank-level structure.

In addition, a power conversion system (PCS) 40 installed in each battery section may actually perform charging/discharging based on a charge/discharge command from an energy management system (EMS) 30. The power conversion system may include a DC/AC inverter and a controller. Meanwhile, the output of the battery rack 10 may be connected to a power generation device (e.g., phtovoltaic system) and the PCS 40 which is connected to a power grid, through a DC bus. In addition, an energy management system (EMS) 30 or a power management system (PMS) may control the energy storage system in overall.

The battery rack 10 may include a battery protection unit (BPU), or a BPU may be placed at the input/output terminal of the battery rack 10. The BPU is a device for protecting the battery from abnormal current and fault current in a battery rack. The BPU may include a main contactor (MC), a fuse, a circuit breaker (CB), or a disconnect switch (DS). The BPU may control the battery system rack by rack by controlling the main contactor on/off according to control of the RBMS. The BPU may also protect the battery from short-circuit current by using a fuse when a short-circuit occurs. As such, the existing battery system may be controlled through a protection device such as a BPU or a switch gear.

In the case of a battery rack to which a BPU is applied, individual battery rack control considering the individual characteristics of the battery rack, such as battery capacity, SOH, and SOC, is impossible. To overcome this limitation, a bidirectional DC/DC converter may be installed for each battery rack. In this case, a battery system controller (BSC) 20 may determine an output reference for each DC/DC converter by considering status of each battery rack and transmit the output reference to each DC/DC converter.

Meanwhile, the battery racks illustrated in FIG. 1 are connected in parallel to the DC link and the DC link is connected to the DC side of the PCS 40. Unlike FIG. 1, a PCS (DC/AC inverter) may individually be applied to each of the battery racks and the AC side of each PCS may be connected to the AC link and linked to the grid.

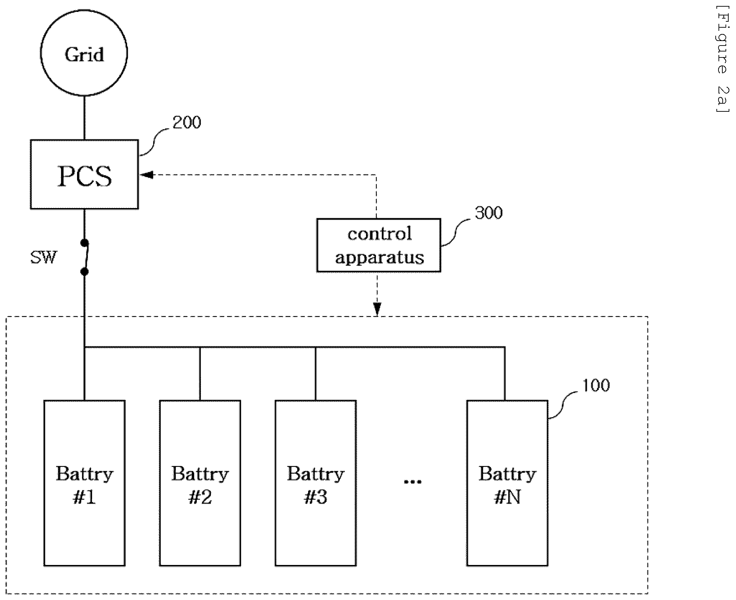

FIG. 2a is a block diagram of an energy storage system according to an embodiment of the present invention.

Referring to FIG. 2a, the energy storage system may include a battery system including a plurality of batteries 100, a power conversion device (PCS) 200 that is connected to the battery system, and a control apparatus 300 that controls one or more of the battery system and the PCS.

In the present invention, the battery 100 may mean a battery rack, but the scope of the present invention is not limited thereto.

The plurality of batteries 100 may be connected in parallel to each other on a DC link.

The battery system may include at least one of a battery having a BPU arranged at an input/output terminal of the battery (hereinafter, a BPU-applied battery) and a battery having a bidirectional DC/DC converter arranged at an input/output terminal of the battery (hereinafter, a DC/DC-applied battery). For example, all batteries included in the battery system may be BPU-applied batteries or DC/DC-applied batteries. For another example, at least some of the batteries included in the battery system may be BPU-applied batteries and the rest may be DC/DC-applied batteries.

The PCS 200 may include a DC/AC inverter of which the DC side terminal may be connected to the DC link and the AC side terminal may be connected to the AC link.

A switching device (SW) may be placed between the DC side terminal of the PCS 200 and the DC link. Here, the switching device may be a circuit protection switch located inside a distribution terminal box.

The control apparatus 300 may be connected with the battery system and the PCS 200 and monitor and control the status of the battery system and the PCS 200. Here, the control apparatus 300 may correspond to an EMS or a BSC, or may be implemented as included in an EMS or a BSC.

The control apparatus 300 may monitor whether a fire has occurred in the battery system.

When a fire has occurred in the battery system, the control apparatus 300 may perform control measures to prevent spread of the fire.

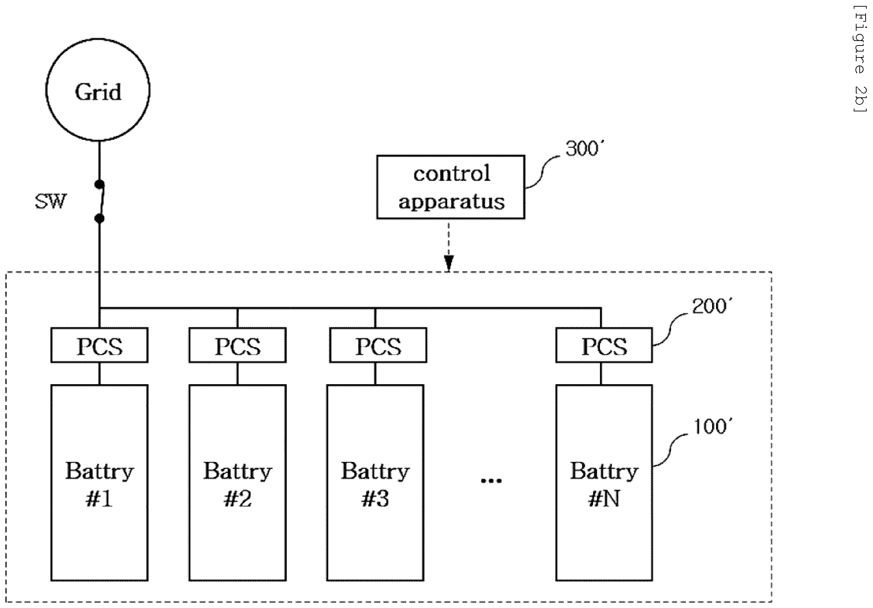

FIG. 2b is a block diagram of an energy storage system according to another embodiment of the present invention.

Referring to FIG. 2b, the energy storage system may include a battery system including a plurality of batteries 100' and a control apparatus 300' that controls the battery system.

The battery system may include PCSs 200' arranged at each input/output terminal of the plurality of batteries 100'.

The PCS 200' may include a DC/AC inverter of which the DC side terminal may be connected to the input/output terminal of the battery 100' and the AC side terminal may be connected to the AC link.

The plurality of PCSs 200' may be connected in parallel to each other on the AC link.

A switching device (SW) may be arranged between the DC side terminal of the PCS 200' and the AC link.

The control apparatus 300' may monitor and control status of the batteries and the PCS 200' in conjunction with the battery system. Here, the control apparatus 300' may correspond to an EMS or BSC, or may be implemented as included in an EMS or BSC.

The control apparatus 300' may monitor whether a fire occurs in the battery system.

When a fire occurs in the battery system, the control apparatus 300' may perform control measures to prevent spread of the fire.

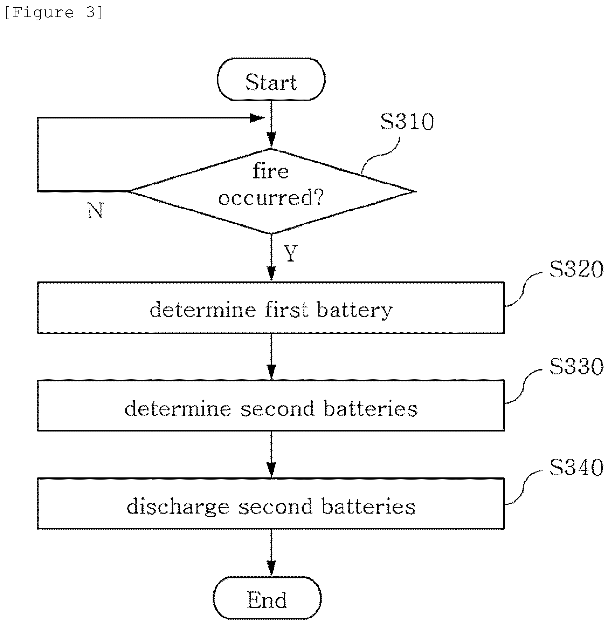

FIG. 3 is an operational flowchart of a control method of an energy storage system according to embodiments of the present invention.

The control method according to embodiments of the present invention may be performed by a control apparatus located within an energy storage system.

The control apparatus may monitor whether a fire has occurred in the battery system (S310).

Here, the control apparatus may detect whether a fire has occurred by interlocking with the BMS of each battery, or may detect whether a fire has occurred by interlocking with at least one of a temperature sensor and a smoke detection sensor located in the battery system.

If a fire has been detected (Y of S310), the control apparatus may determine a battery in which a fire has occurred (hereinafter, referred to as a first battery) among the batteries included in the battery system (S320). For example, the control apparatus 300 may determine a battery having a temperature exceeding a predetermined threshold as a battery in which a fire has occurred.

Thereafter, the control apparatus may determine one or more second batteries within a predetermined distance range from the first battery (S330). Here, the second battery may mean a battery that is additionally likely to be ignited by the first battery.

The distance range for determining the one or more second batteries may be predefined based on temperature distribution according to distance from the ignited battery.

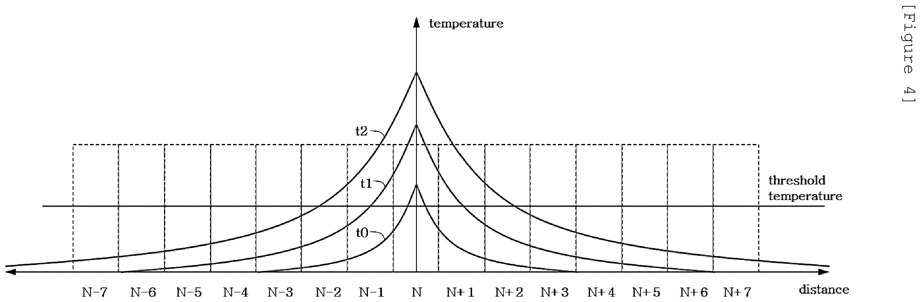

FIG. 4 is a reference diagram for explaining a method for determining a second battery according to embodiments of the present invention.

FIG. 4 shows a graph of temperature change according to the distance from an ignited battery (N) when a fire occurs in a specific battery (N) among a plurality of batteries arranged in a single row. Referring to FIG. 4, at the initial time point t0 of a fire, heat diffusion to surrounding batteries is minimal, but after a certain period of time has elapsed, which is time point of t1, heat may spread to batteries located far from the ignited battery. At the time point t2 when the ignited battery (N) reaches a saturation temperature, heat may spread to all batteries. Here, during the period (t0 to t2) until the ignited battery (N) reaches a saturation temperature, if the temperature of a specific battery exceeds a predetermined threshold temperature (e.g., ignition temperature), a fire may occur in the battery due to the spread heat. Therefore, a battery with ignition risk (second battery) may be determined as a battery that shows a temperature exceeding a predetermined threshold temperature during the period from the ignition time point to a time point when the ignited battery reaches the maximum temperature. In the case of FIG. 4, batteries N-2 to N+2 centered on the ignited battery (N) may be determined as the second batteries.

Meanwhile, unlike FIG. 4, even when multiple batteries are arranged in a matrix form (e.g., 8 rows and 8 columns), the second battery may be determined based on the temperature distribution according to the distance, centered on the ignited battery (N).

Referring again to FIG. 3, the control apparatus may control one or more of the battery system and the power conversion device to discharge the power stored in the second batteries (S340).

In a first embodiment, the control apparatus may control power stored in the second batteries to be discharged to the AC link side. Here, the control apparatus may control at least one of the battery system and the power conversion device to block charge/discharge paths of the remaining batteries except for the second batteries and to discharge the power stored in the second batteries to the AC link side through the PCS.

In a second embodiment, the control apparatus may select one or more third batteries that may be charged among the batteries except for the first battery and the second batteries, and control the power stored in the second batteries to be discharged to the third battery side. For example, the control apparatus that is linked with the battery system including DC/DC-applied batteries may block a connection path between the PCS and the battery system and control one or more of the DC/DC converters linked with the second batteries and the DC/DC converters linked with the third batteries to discharge the power stored in the second batteries to the third battery side.

The control apparatus may control the discharge of the second batteries to be stopped when the SOC of the second batteries decreases below a predefined SOC.

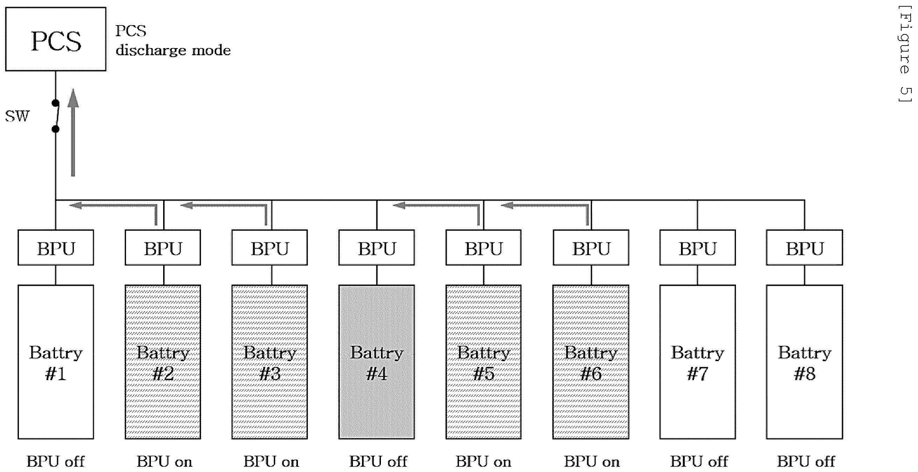

FIGS. 5 to 8 are reference drawings for explaining a control method of an energy storage system according to embodiments of the present invention.

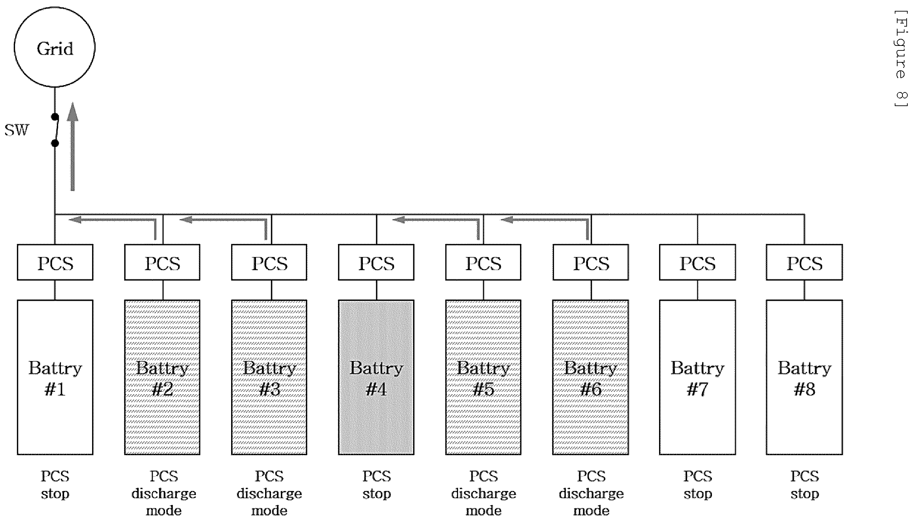

Specifically, FIGS. 5 to 8 are drawings for explaining a control method according to the first embodiment of the present invention, FIGS. 5 to 7 are drawings for explaining a control method that may be performed in the energy storage system shown in FIG. 2a, and FIG. 8 is a drawing for explaining a control method that may be performed in the energy storage system shown in FIG. 2b.

FIG. 5 shows a control method of an energy storage system including BPU-applied batteries.

When detecting a fire, the control apparatus may switch the PCS to stop mode and switch the BPUs of all batteries to off state to block the charge and discharge paths of the batteries. Here, the off state of the BPU may mean a state in which a switching device (e.g., a main contactor or a circuit breaker) included in the BPU is opened and the electrical connection between the battery and the DC link is blocked. In addition, the on state of the BPU may mean a state in which the switching device included in the BPU is closed and thus, the battery and the DC link are electrically connected.

If battery #4 is determined to be the ignited battery (first battery), the control apparatus may determine batteries (batteries #2, #3, #5, #6) within a predetermined distance range (for example, batteries N-2 to N+2) from battery #4 as the second batteries.

Thereafter, the control apparatus may switch the BPUs of the second batteries (batteries #2, #3, #5, #6)) to an ON state and switch the PCS to discharge mode. Accordingly, power stored in the second batteries (batteries #2, #3, #5, #6) may be discharged to the AC link side through the PCS.

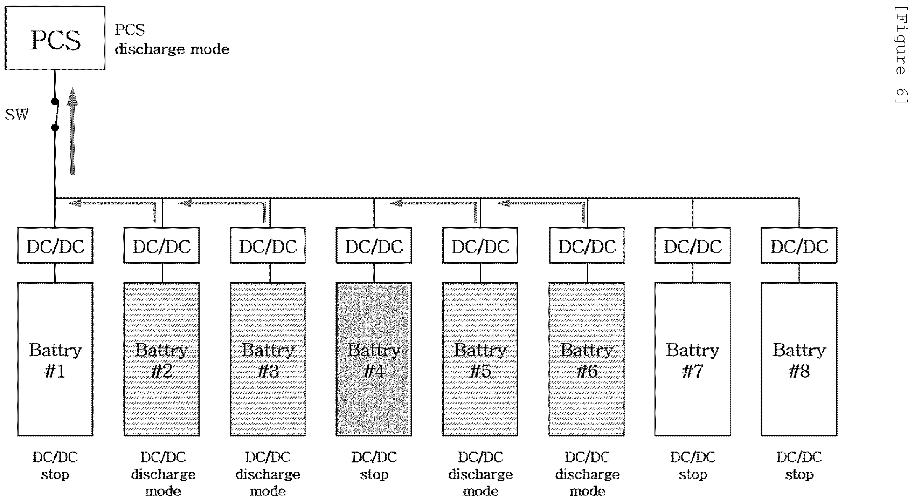

FIG. 6 illustrates a control method of an energy storage system including DC/DC-applied batteries.

When detecting a fire, the control apparatus may switch the PCS to stop mode and switch the DC/DC converters of all batteries to stop mode to block the charge/discharge paths of the batteries.

If battery #4 is determined to be the ignited battery (first battery), the control apparatus may determine batteries (batteries #2, #3, #5, #6) within a predetermined distance range (for example, batteries N-2 to N+2) from battery #4 as the second batteries.

Thereafter, the control apparatus may switch the DC/DC converters of each second batteries (batteries #2, #3, #5, #6) to discharge mode and switch the PCS to discharge mode. Accordingly, power stored in the second batteries (batteries #2, #3, #5, #6) may be discharged to the AC link side through the PCS.

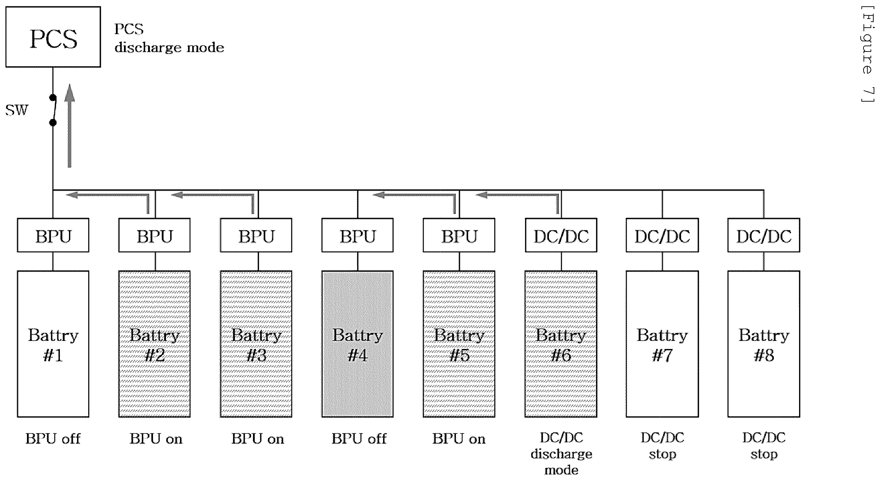

FIG. 7 illustrates a control method of an energy storage system including a BPU-applied battery and a DC/DC-applied battery.

When detecting a fire, the control apparatus may switch the PCS to stop mode, switch the BPUs of the BPU-applied batteries to off state, and switch the DC/DC converters of the DC/DC-applied batteries to stop mode to block the charge/discharge paths of the batteries.

If battery #4 is determined to be the ignited battery (first battery), the control apparatus may determine batteries (batteries #2, #3, #5, #6) within a predetermined distance range (for example, N-2 to N+2) from battery #4 as the second batteries.

Thereafter, the control apparatus may switch the BPUs of the BPU-applied batteries (batteries #2, #3, #5) among the second batteries to ON state, switch the DC/DC converter of the DC/DC-applied battery (battery #6) among the second batteries to discharge mode, and switch the PCS to discharge mode. Accordingly, the power stored in the second batteries (batteries #2, #3, #5, #6) may be discharged to the AC link side through the PCS.

FIG. 8 shows a control method of an energy storage system including PCS-applied batteries.

When detecting a fire, the control apparatus may switch all PCSs (DC/AC inverters) to stop mode to block the charging/discharging paths of the batteries.

If battery #4 is determined to be an ignited battery (first battery), the control apparatus may determine batteries (batteries #2, #3, #5, #6) within a predetermined distance range (for example, N-2 to N+2) from battery #4 as the second batteries.

Thereafter, the control apparatus may switch the PCSs of respective second batteries (batteries #2, #3, #5, #6) to discharge mode. Accordingly, the power stored in the second batteries (batteries #2, #3, #5, #6) may be discharged to the AC link side through respective PCSs of the second batteries (batteries #2, #3, #5, #6).

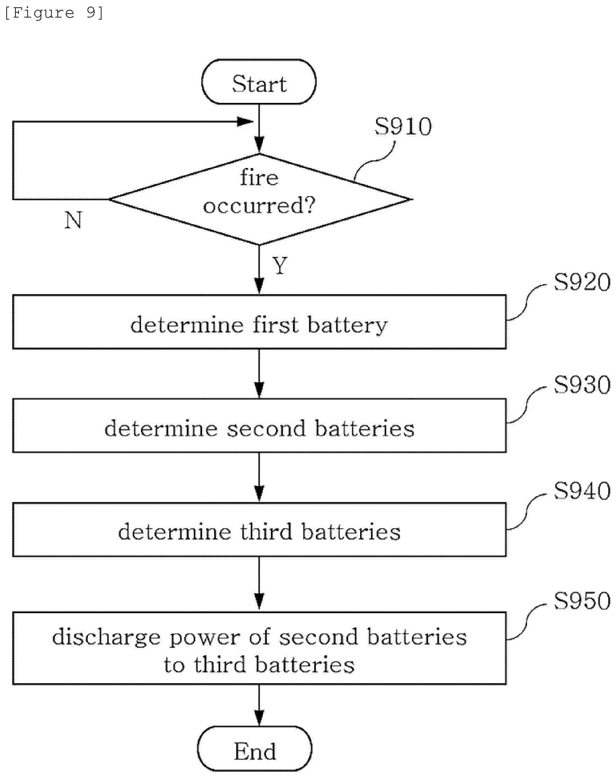

FIG. 9 is an operational flowchart of a control method of an energy storage system according to another embodiment of the present invention. Specifically, FIG. 9 shows a control method according to the second embodiment of the present invention.

The control apparatus may monitor whether a fire has occurred in the battery system (S910).

If a fire has been detected (Y of S910), the control apparatus may determine a battery in which a fire has occurred (hereinafter, a first battery) among the batteries included in the battery system (S920).

The control apparatus may determine one or more second batteries within a predetermined distance range from the first battery (S930).

The control apparatus may select one or more third batteries that is chargeable among the batteries except for the first battery and the one or more second batteries (S940). Here, the control apparatus may determine a battery having a predetermined SOC or lower among the batteries except for the first battery and the second battery as a third battery.

The control apparatus may control at least one of the battery system and the power conversion device to discharge power stored in the second battery toward the third battery side (S950).

For example, a control apparatus interlocked with a battery system including DC/DC-applied batteries may block a connection path between the PCS and the battery system, and control at least one of a DC/DC converter interlocked with the second battery and a DC/DC converter interlocked with the third battery to discharge power stored in the second battery to the third battery. Accordingly, the third battery may be charged through the stored power of the second battery.

The control apparatus may define discharge priorities for a plurality of second batteries and control the plurality of second batteries to be discharged sequentially according to the discharge priorities.

The discharge priorities may be defined based on at least one of a state of charge (SOC), state of health (SOH), and distance from the first battery of each battery. Here, a closer distance from the first battery, a higher SOC, or a higher SOH may be defined as a higher priority.

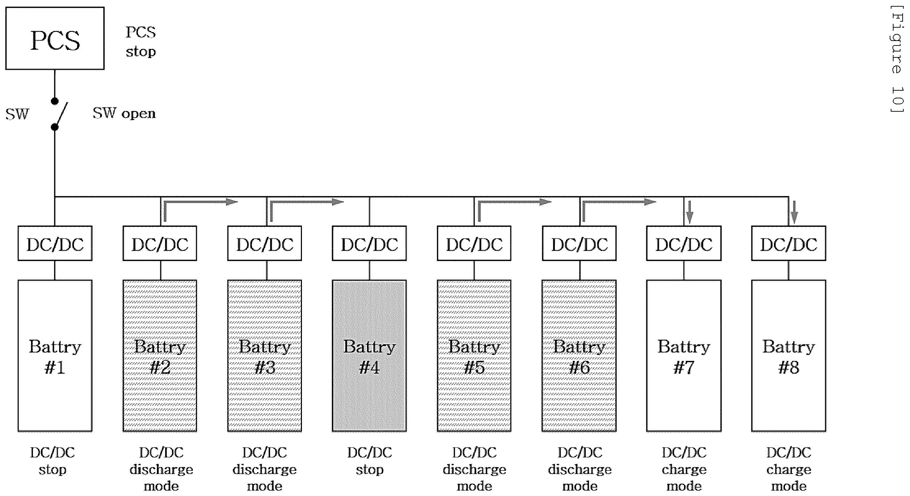

For example, in FIG. 10, among the second batteries (batteries #2, #3, #5, #6), battery #3 and battery #5, which are closest to the first battery (battery #4), may be defined as having a higher discharge priority, and battery #2 and battery #6, which are farthest, may be defined as having a lower discharge priority. Here, if the SOC of battery #3 is higher than that of battery #5, and the SOC of battery #2 is higher than that of battery #6, the discharge priority may be defined in the order of battery #3, battery #5, battery #2, and battery #6.

The control apparatus may monitor the temperature of the first battery during process of sequentially discharging a plurality of second batteries according to the discharge priorities, and control the sequential discharge of the second batteries to be stopped when the temperature of the first battery becomes lower than a predetermined temperature. For example, if the temperature of the first battery is determined to be lower than the set temperature after the discharge of battery #3 according to the discharge priority is completed, the control apparatus may terminate the control measure for preventing the spread of fire without discharging the remaining second batteries (batteries #5, #2, #6).

FIGS. 10 to 13 are reference diagrams for explaining a control method of an energy storage system according to another embodiment of the present invention.

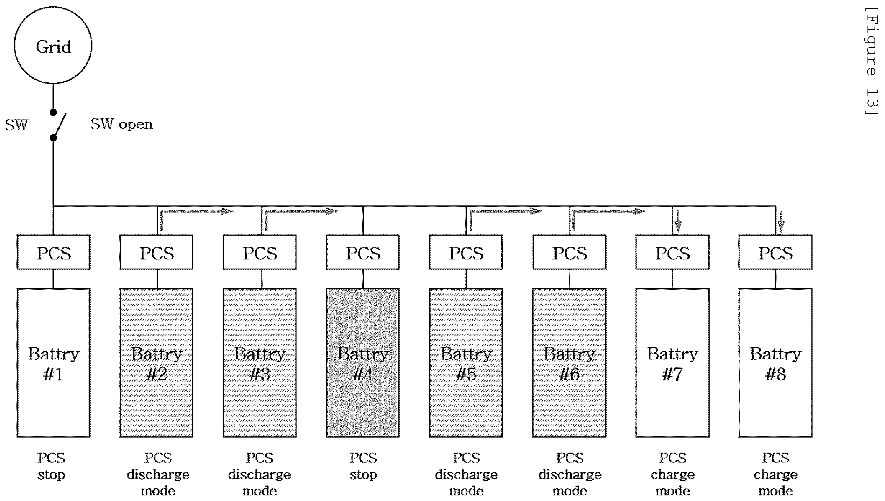

Specifically, FIGS. 10 to 13 are diagrams for explaining a control method according to the second embodiment, FIGS. 10 to 12 are diagrams for explaining a control method that may be performed in the energy storage system in FIG. 2a, and FIG. 13 is a diagram for explaining a control method that may be performed in the energy storage system in FIG. 2b.

FIG. 10 shows a control method of an energy storage system including DC/DC-applied batteries.

When detecting a fire, the control apparatus may switch the PCS to stop mode and open the switching device (SW) arranged between the DC side terminal of the PCS and the DC link, thereby cutting off the electrical connection between the PCS and the battery system. In addition, the control apparatus may switch the DC/DC converters of all batteries to stop mode, thereby cutting off the charge/discharge paths of the batteries.

If battery #4 is determined to be an ignited battery (first battery), the control apparatus may determine batteries (batteries #2, #3, #5, #6) within a predetermined distance range (e.g., batteries N-2 to N+2) from battery #4 as the second batteries.

In addition, the control apparatus may determine chargeable batteries (e.g., batteries #7, #8) among the remaining batteries except for the first and second batteries as the third batteries.

Thereafter, the control apparatus may switch the DC/DC converters of respective second batteries (batteries #2, #3, #5, #6) to discharge mode and switch the DC/DC converters of respective third batteries (batteries #7, #8) to charge mode. Accordingly, the stored power of the second batteries (batteries #2, #3, #5, #6) may be discharged and the third batteries (batteries #7, #8) may be charged.

If battery #3 and battery #5, among the second batteries, are defined as first-priority discharge batteries and batteries #2 and #6 are defined as second-priority discharge batteries, the control apparatus may switch the DC/DC converters of battery #3 and battery #5 to discharge mode so that the batteries with the first-priority discharge are discharged first. When battery #3 and battery #5 are discharged to a predefined SOC, the control apparatus may switch the DC/DC converters of battery #3 and battery #5 to stop mode and switch the DC/DC converters of battery #2 and battery #6 to discharge mode so that the batteries with the second-priority discharge is discharged.

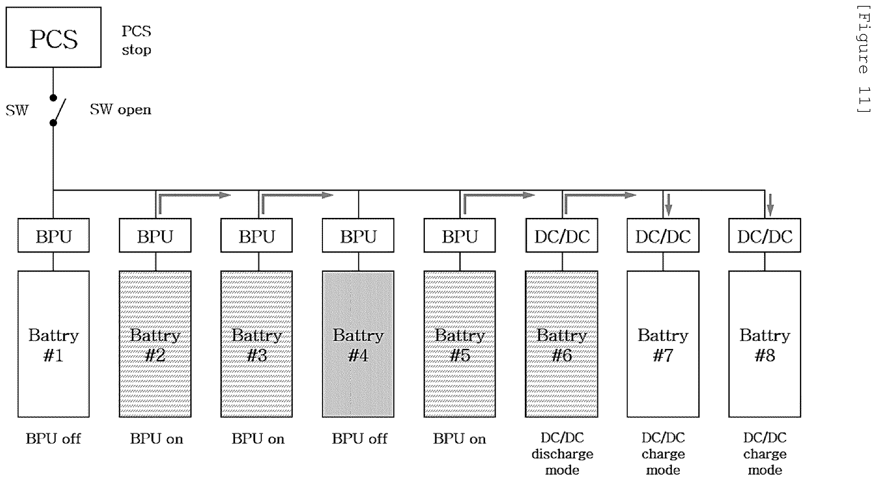

FIG. 11 shows a control method of an energy storage system including a BPU-applied battery and a DC/DC-applied battery.

When a fire is detected, the control apparatus may switch the PCS to stop mode and open a switching device (SW) arranged between the DC side terminal of the PCS and the DC link, thereby blocking the electrical connection between the PCS and the battery system. In addition, the control apparatus may switch the BPUs of the BPU-applied batteries to an off state and switch the DC/DC converters of the DC/DC-applied batteries to stop mode, thereby blocking the charge/discharge paths of the batteries.

When battery #4 is determined to be an ignited battery (first battery), the control apparatus may determine batteries (batteries #2, #3, #5, #6) within a predetermined distance range (e.g., batteries N-2 to N+2) from battery #4 as the second batteries.

In addition, the control apparatus may determine chargeable batteries (for example, batteries #7 and 8) among the remaining batteries except for the first and second batteries as the third batteries.

Thereafter, the control apparatus may switch the BPUs of the BPU-applied batteries (batteries #2, #3, #5) among the second batteries to an ON state, switch the DC/DC converter of the DC/DC-applied battery (battery #6) among the second batteries to discharge mode, and switch the DC/DC converters of the third batteries (batteries #7, #8) to charge mode. Accordingly, the stored power of the second batteries (batteries #2, #3, #5, #6) may be discharged and the third batteries (batteries #7, #8) may be charged.

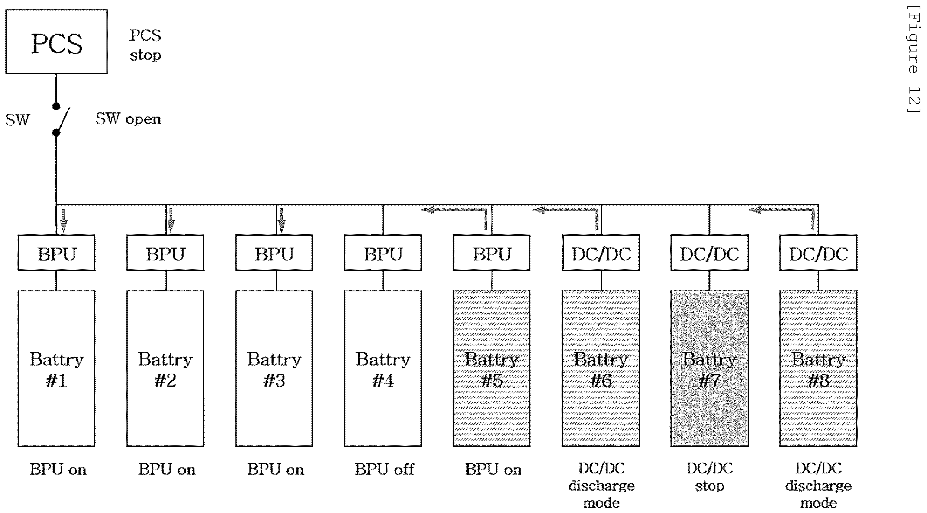

FIG. 12 shows an example as a control method of an energy storage system including a BPU-applied battery and a DC/DC-applied battery, which is different from one in FIG. 11.

When detecting a fire, the control apparatus may switch the PCS to stop mode and switch a switching device (SW) arranged between the DC side terminal of the PCS and the DC link to an open state, thereby blocking the electrical connection between the PCS and the battery system. In addition, the control apparatus may switch the BPUs of the BPU-applied batteries to an off state and switch the DC/DC converter of the DC/DC-applied battery to stop mode, thereby blocking the charge/discharge routes of the batteries.

If battery #7 is determined to be an ignited battery (first battery), the control apparatus may determine batteries (batteries #5, 6, and 8) within a predetermined distance range (for example, N-2 to N+2) from battery #7 as the second batteries.

In addition, the control apparatus may determine chargeable batteries (for example, battery #1, #2, #3) among the remaining batteries except for the first battery and the second batteries as the third batteries.

Thereafter, the control apparatus may switch the BPU of the BPU-applied battery (battery #5) among the second batteries to an ON state, switch the DC/DC converters of the DC/DC-applied batteries (battery #6, #8) among the second batteries to discharge mode, and switch the BPUs of the third batteries (battery #1, #2, #3) to an ON state. Accordingly, the stored power of the second batteries (batteries #5, #6, #8) may be discharged and the third batteries (battery #1, #2, #3) may be charged.

FIG. 13 shows a control method of an energy storage system including PCS-applied batteries.

When detecting a fire, the control apparatus may switch all PCSs (DC/AC inverters) to stop mode and switch a switching device (SW) placed between the grid and the AC link to an open state to block the electrical connection between the battery system and the grid.

When battery #4 is determined to be an ignited battery (first battery), the control apparatus may determine batteries (batteries #2, #3, #5, #6) within a predetermined distance range (e.g., N-2 to N+2) from battery #4 as the second batteries.

In addition, the control apparatus may determine chargeable batteries (e.g., batteries #7, #8) among the remaining batteries except for the first and second batteries as the third batteries.

Thereafter, the control apparatus may switch the PCSs of respective second batteries (batteries #2, #3, #5, #6) to discharge mode and switch the PCSs of respective third batteries (batteries #7, 8) to charge mode. Accordingly, the stored power of the second batteries (batteries #2, #3, #5, #6) may be discharged and the third batteries (batteries #7, #8) may be charged.

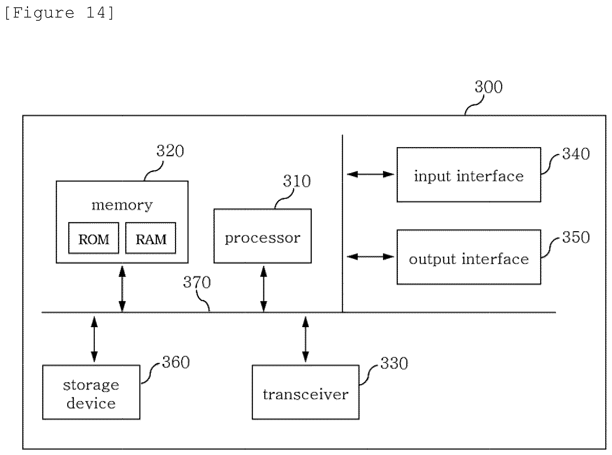

FIG. 14 is a block diagram of a control apparatus of an energy storage system according to embodiments of the present invention.

The control apparatus 300 may be located in an energy storage system including a plurality of batteries and one or more power conversion systems (PCS) that are linked to the batteries. Here, the control apparatus 300 may correspond to an energy management system (EMS) or a battery system controller (BSC), or may be implemented by being included in an EMS or a BSC.

The control apparatus 300 may include at least one processor (310), a memory (320) storing at least one command executed through the processor, and a transceiver (330) connected to a network to perform communication.

The at least one instruction may include an instruction to monitor whether a fire has occurred in the plurality of batteries; an instruction to, upon detecting fire occurred, determine a first battery in which a fire has occurred, among the plurality of batteries; an instruction to determinine one or more second batteries within a predetermined distance range from the first battery; and an instruction to control power stored in the one or more second batteries to be discharged.

The instruction to control power stored in the one or more second batteries to be discharged may include an instruction to control charge and discharge paths of the remaining batteries, except for the second batteries, to be blocked; and an instruction to control power stored in the second batteries to be discharged to an AC link side through the PCS.

The instruction to control power stored in the one or more second batteries to be discharged may include an instruction to select one or more third batteries that are chargeable among the batteries except for the first and the one or more second batteries; and an instruction to control the power stored in the one or more second batteries to be discharged toward the one or more third batteries.

The instruction to control power stored in the one or more second batteries to be discharged may include an instruction to control one or more PCSs connected to a DC link of the batteries into stop mode and to control one or more DC/DC converters which are connected with the one or more second batteries into discharge mode, thereby discharging the power stored in the one or more second batteries toward the one or more third batteries.

The instruction to control power stored in the one or more second batteries to be discharged may include an instruction to control one or more PCSs connected to a DC link of the batteries into stop mode and to control one or more DC/DC converters which are connected with the one or more third batteries into charge mode, thereby discharging the power stored in the one or more second batteries toward the one or more third batteriess.

The instruction to control power stored in the one or more second batteries to be discharged may include an instruction to control one or more PCSs connected to the one or more second batteries into discharge mode and to control the PCS connected to the one or more third batteries into charge mode, thereby discharging the power stored in the one or more second batteries toward the one or more third batteries.

The instruction to control power stored in the one or more second batteries to be discharged may include an instruction to define a discharge priority for each of a plurality of second batteries; and an instruction to control the plurality of second batteries to be sequentially discharged according to the discharge priority. Here, the instruction to define the discharge priority may include an instruction to define the discharge priority based on at least one of a state of charge (SOC), a state of Health (SOH), and a distance from the first battery.

The instruction to control the plurality of second batteries to be sequentially discharged may include an instruction to monitor temperature of the first battery; and an instruction to control the discharge of the plurality of second batteries to be stopped when the temperature of the first battery falls below a predetermined temperature.

In addition, the control apparatus 300 according to embodiments of the present invention may further include an input interface device 340, an output interface device 350, a storage device 360, etc. Respective components included in the control apparatus 300 may be connected by a bus 370 and may communicate with each other.

Here, the processor 310 may be a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An energy storage system comprising:
a plurality of batteries;
one or more power conversion system connected with the plurality of batteries; and
a control apparatus configured to monitor whether a fire occurs in the plurality of batteries,
wherein the control apparatus determines one or more second batteries within a predetermined distance range from a first battery where a fire has occurred and controls the one or more power conversion systems so that power stored in the one or more second batteries is discharged.

2. The energy storage system of claim 1, wherein the control apparatus controls so that charge and discharge paths of the remaining batteries except for the one or more second batteries are blocked and controls so that power stored in the one or more second batteries is discharged to an AC link side through the power conversion system.

3. The energy storage system of claim 1, wherein the control apparatus selects one or more third batteries that are chargeable among the batteries except for the first and the one or more second batteries and controls the power stored in the one or more second batteries to be discharged toward the one or more third batteries.

4. The energy storage system of claim 3, wherein the control apparatus controls one or more power conversion systems connected to a DC link of the plurality of batteries into stop mode and controls one or more DC/DC converters which are connected with the one or more second batteries into discharge mode, thereby discharging the power stored in the one or more second batteries toward the one or more third batteries.

5. The energy storage system of claim 3, wherein the control apparatus controls one or more power conversion systems connected to a DC link of the plurality of batteries into stop mode and controls one or more DC/DC converters which are connected with the one or more third batteries into charge mode, thereby discharging the power stored in the one or more second batteries toward the one or more third batteriess.

6. The energy storage system of claim 3, wherein the control apparatus controls one or more power conversion systems connected to the one or more second batteries into discharge mode and controls the power conversion system connected to the one or more third batteries into charge mode, thereby discharging the power stored in the one or more second batteries toward the one or more third batteries.

7. The energy storage system of claim 1, wherein the control apparatus defines a discharge priority for each of a plurality of second batteries and controls the plurality of second batteries to be sequentially discharged according to the discharge priority.

8. The energy storage system of claim 7, wherein the control apparatus defines the discharge priority based on at least one of a state of charge, a state of Health, and a distance from the first battery.

9. The energy storage system of claim 7, wherein the control apparatus monitors temperature of the first battery and controls the discharge of the plurality of second batteries to be stopped when the temperature of the first battery falls below a predetermined temperature.

10. A control apparatus of an energy storage system including a plurality of batteries and one or more power conversion system connected with the plurality of batteries, the control apparatus comprising:
at least one processor; and
a memory configured to store at least one instruction executed by the at least one processor,
wherein the at least one instruction includes:
an instruction to monitor whether a fire has occurred in the plurality of batteries;
an instruction to, upon detecting fire occurred, determine a first battery in which a fire has occurred, among the plurality of batteries;
an instruction to determinine one or more second batteries within a predetermined distance range from the first battery; and
an instruction to control power stored in the one or more second batteries to be discharged.

11. The control apparatus of claim 10, wherein the instruction to control power stored in the one or more second batteries to be discharged includes:
an instruction to control charge and discharge paths of the remaining batteries, except for the one or more second batteries, to be blocked; and
an instruction to control power stored in the one or more second batteries to be discharged to an AC link side through the power conversion system.

12. The control apparatus of claim 10, wherein the instruction to control power stored in the one or more second batteries to be discharged includes:
an instruction to select one or more third batteries that are chargeable among the batteries except for the first and the one or more second batteries; and
an instruction to control the power stored in the one or more second batteries to be discharged toward the one or more third batteries.

13. The control apparatus of claim 12, wherein the instruction to control power stored in the one or more second batteries to be discharged includes:
an instruction to control one or more power conversion systems connected to a DC link of the plurality of batteries into stop mode and to control one or more DC/DC converters which are connected with the one or more second batteries into discharge mode, thereby discharging the power stored in the one or more second batteries toward the one or more third batteries.

14. The control apparatus of claim 12, wherein the instruction to control power stored in the one or more second batteries to be discharged includes:
an instruction to control one or more power conversion systems connected to a DC link of the plurality of batteries into stop mode and to control one or more DC/DC converters which are connected with the one or more third batteries into charge mode, thereby discharging the power stored in the one or more second batteries toward the one or more third batteriess.

15. The control apparatus of claim 12, wherein the instruction to control power stored in the one or more second batteries to be discharged includes:
an instruction to control one or more power conversion systems connected to the one or more second batteries into discharge mode and to control the power conversion system connected to the one or more third batteries into charge mode, thereby discharging the power stored in the one or more second batteries toward the one or more third batteries.

16. The control apparatus of claim 10, wherein the instruction to control power stored in the one or more second batteries to be discharged includes:
an instruction to define a discharge priority for each of a plurality of second batteries; and
an instruction to control the plurality of second batteries to be sequentially discharged according to the discharge priority.

17. The control apparatus of claim 16, wherein the instruction to define the discharge priority includes:
an instruction to define the discharge priority based on at least one of a state of charge, a state of Health, and a distance from the first battery.

18. The control apparatus of claim 16, wherein the instruction to control the plurality of second batteries to be sequentially discharged includes:
an instruction to monitor temperature of the first battery; and
an instruction to control the discharge of the plurality of second batteries to be stopped when the temperature of the first battery falls below a predetermined temperature.

19. A control method of an energy storage system including a plurality of batteries and one or more power conversion system connected with the plurality of batteries, the method comprising:
monitoring whether a fire has occurred in the plurality of batteries;
upon detecting fire occurred, determining a first battery in which a fire has occurred, among the plurality of batteries;
determining one or more second batteries within a predetermined distance range from the first battery; and
controlling power stored in the one or more second batteries to be discharged.

20. The control method of claim 19, wherein the controlling power stored in the one or more second batteries to be discharged includes:
controlling charge and discharge paths of the remaining batteries, except for the one or more second batteries, to be blocked; and
controlling power stored in the one or more second batteries to be discharged to an AC link side through the power conversion system.

21. The control method of claim 19, wherein the controlling power stored in the one or more second batteries to be discharged includes:
selecting one or more third batteries that are chargeable among the batteries except for the first and second batteries; and
controlling the power stored in the one or more second batteries to be discharged toward the one or more third batteries.

22. The control method of claim 21, wherein the controlling power stored in the one or more second batteries to be discharged includes:
controlling one or more power conversion systems connected to a DC link of the plurality of batteries into stop mode and controlling one or more DC/DC converters which are connected with the one or more second batteries into discharge mode, thereby discharging the power stored in the one or more second batteries toward the one or more third batteries.

23. The control method of claim 21, wherein the controlling power stored in the one or more second batteries to be discharged includes:
controlling one or more power conversion systems connected to a DC link of the plurality of batteries into stop mode and controlling one or more DC/DC converters which are connected with the one or more third batteries into charge mode, thereby discharging the power stored in the one or more second batteries toward the one or more third batteriess.

24. The control method of claim 21, wherein the controlling power stored in the one or more second batteries to be discharged includes:
controlling one or more power conversion systems connected to the one or more second batteries into discharge mode and controlling the power conversion system connected to the one or more third batteries into charge mode, thereby discharging the power stored in the one or more second batteries toward the one or more third batteries.

25. The control method of claim 19, wherein the controlling power stored in the one or more second batteries to be discharged includes:
defining a discharge priority for each of a plurality of second batteries; and
controlling the plurality of second batteries to be sequentially discharged according to the discharge priority.

26. The control method of claim 25, wherein the defining the discharge priority includes:
defining the discharge priority based on at least one of a state of charge, a state of Health, and a distance from the first battery.

27. The control method of claim 25, wherein the controlling the plurality of second batteries to be sequentially discharged includes:
monitoring temperature of the first battery; and
controlling the discharge of the plurality of second batteries to be stopped when the temperature of the first battery falls below a predetermined temperature.
